(19) **Europäisches Patentamt**
**European Patent Office**
**Office européen des brevets**

(11) **EP 1 428 202 B1**

(12) **EUROPEAN PATENT SPECIFICATION**

(45) Date of publication and mention
of the grant of the patent:
**05.08.2009 Bulletin 2009/32**

(51) Int Cl.:
**G10L 19/08** (2006.01)

(21) Application number: **02727961.1**

(22) Date of filing: **07.06.2002**

(86) International application number:
**PCT/IB2002/002078**

(87) International publication number:
**WO 2002/101718 (19.12.2002 Gazette 2002/51)**

(54) **METHOD AND APPARATUS FOR CODING SUCCESSIVE PITCH PERIODS IN SPEECH SIGNAL**

VERFAHREN UND VORRICHTUNG ZUR CODIERUNG AUFEINANDERFOLGENDER
GRUNDPERIODEN IN EINEM SPRACHSIGNAL

PROCEDE ET APPAREIL DE CODAGE DE PERIODES FONDAMENTALES SUCCESSIVES DANS
UN SIGNAL DE PAROLE

(84) Designated Contracting States:
**AT BE CH CY DE DK ES FI FR GB GR IE IT LI LU
MC NL PT SE TR**

(30) Priority: **11.06.2001 US 878762**

(43) Date of publication of application:
**16.06.2004 Bulletin 2004/25**

(73) Proprietor: **Qualcomm Incorporated
San Diego, CA 92121 (US)**

(72) Inventors:
• **HEIKKINEN, Ari
FIN-33300 Tampere (FI)**
• **RUOPPILA, Vesa
CA-Montreal(QC) H2L 3R7 (CA)**
• **PIETILÄ, Samuli
FIN-33560 Tampere (FI)**

(74) Representative: **Style, Kelda Camilla Karen et al
Page White & Farrer
Bedford House
John Street
London, WC1N 2BF (GB)**

(56) References cited:
JP-A- 1 020 599           US-A- 5 245 662
US-A- 5 675 702           US-A- 5 729 694
US-A- 6 006 175           US-B1- 6 185 527

• **IRETON M A ET AL: "ON IMPROVING VECTOR
EXCITATION CODERS THROUGH THE USE OF
SPHERICAL LATTICE CODEBOOKS (SLC'S)"
SPEECH PROCESSING 1. GLASGOW, MAY 23 -
26, 1989, INTERNATIONAL CONFERENCE ON
ACOUSTICS, SPEECH & SIGNAL PROCESSING.
ICASSP, NEW YORK, IEEE, US, vol. VOL. 1 CONF.
14, 23 May 1989 (1989-05-23), pages 57-60,
XP000089671**
• **LAMBLIN C ET AL: "FAST CELP CODING BASED
ON THE BARNES-WALL LATTICE IN 16
DIMENSIONS" SPEECH PROCESSING 1.
GLASGOW, MAY 23 - 26, 1989, INTERNATIONAL
CONFERENCE ON ACOUSTICS, SPEECH &
SIGNAL PROCESSING. ICASSP, NEW YORK,
IEEE, US, vol. VOL. 1 CONF. 14, 23 May 1989
(1989-05-23), pages 61-64, XP000089672**
• **LOVISOLO ET AL.: 'Uniform distribution of points
on a hyper-sphere with applications to vector bit-
plane encoding' VISION, IMAGE AND SIGNAL
PROCESSING, IEE PROCEEDINGS- vol. 148, no.
3, June 2001, pages 187 - 193, XP006016907**

**EP 1 428 202 B1**

**Description**

Field of the Invention

The present invention relates generally to the field of speech coding and, in particular, to the quantization of successive pitch periods.

Background of the Invention

Based on the human speech processing mechanism, the pitch period contour of voiced speech evolves slowly in time. This phenomenon is exploited in many current speech coders by coding the difference between successive pitch periods thereby increasing the coding efficiency. In a typical coder operating on a subframe basis, such as the code excited linear predictive (CELP) coder, the absolute pitch period is sent a least once per frame.

The difference between successive pitch periods is generally referred to as a delta period. An examplary coder exploiting such a differential approach is described in US 5 778 334. In prior art, the delta periods may attain uniformly distributed values from a limited range facilitating their coding. This can be interpreted as a multi-dimensional rectangular lattice populated uniformly by points that define the delta periods over the frame. Accordingly, coding of the delta periods is carried out by using a uniform quantizer. That is, similar quantizers are used to code independently several successive delta periods. An encoder that uses such an approach is also known as a multi-dimensional rectangular lattice quantizer. In a multi-dimensional lattice quantizer, each dimension represents a pitch period in a corresponding subframe. Usually, the first dimension of a lattice is indicative of the absolute pitch period in the first subframe, while each of the remaining dimensions represents the difference between the pitch periods of the current and the preceding subframe. Thus, in a speech coding scheme where a speech frame is divided into four subframes for speech processing, the encoder for use in the ' quantization of successive pitch periods is referred to as a four-dimensional lattice quantizer, and the absolute pitch period in the first dimension and the delta periods in the remaining three dimensions are represented by a point $(p, d_1, d_2, d_3)$ in a four-dimensional pitch space. In the present invention, special attention is paid to a lattice structure containing the dimensions only for the delta periods $(d_1, d_2\ d_3, ..., d_n)$.

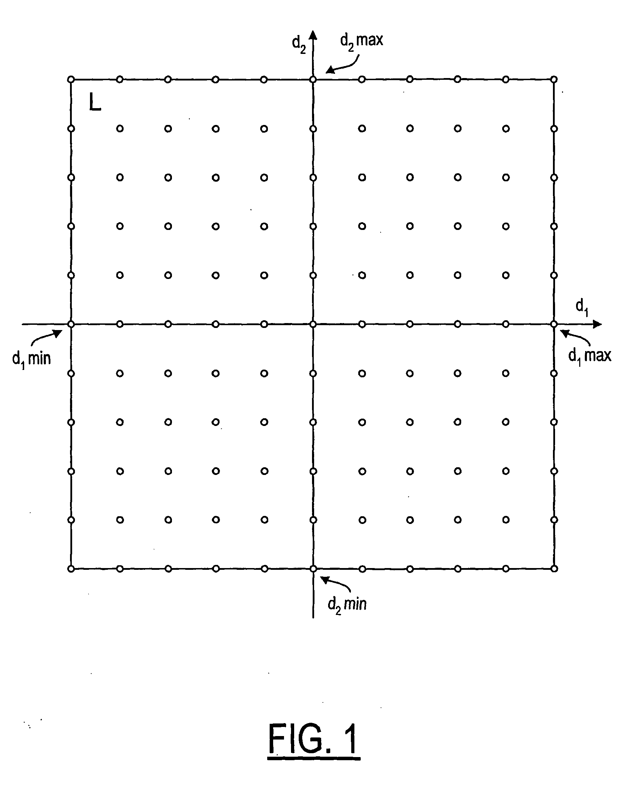

In most prior art speech coders utilizing differential coding, the lattice structure for n delta periods is described as a set of points with a regular arrangement in an n-dimensional pitch space such that the points are uniformly spaced throughout the pitch space. In addition to the uniform spacing of the points in the pitch space, the key feature of the prior art speech coders is the rectangular shape of the projection of the lattice points onto a two-dimensional plane. The structure of the lattice is usually constant regardless of the pitch period in the previous segment. An example of a typical two-dimensional lattice for delta periods is presented in Figure 1, where the lattice $L$ is defined by

$$L = \{(d_1, d_2) \mid d_{1\min} \le d_1 \le d_{1\max} \ \wedge \ d_{2\min} \le d_2 \le d_{2\max}\} \qquad (1)$$

The lattice covers all possible combination of $d_1$ and $d_2$ between their respective minimum and maximum values. While the lattice, as shown in Figure 1, is two-dimensional, higher dimensional lattices can be easily derived from the two-dimensional case. In general, the minimum and maximum possible delta periods for the $j$th dimension are denoted by $d_{j min}$ and $d_{j max}$, respectively.

Once the shape and the region of the lattice quantizer are defined, an important parameter is the density of the lattice, for the density determines the bit rate of the coder. The bit rate is a monotonically increasing function of the density. Thus, the density of the lattice quantizer reflects the accuracy used for pitch period information. Normally, fractional values are used instead of integers to improve the quality of the synthesized speech.

In a typical lattice quantizer for delta periods, attention is usually paid to the boundary values $(d_{j min}, d_{j max})$ of the lattice while the rectangular shape of the lattice is kept constant. Attention is not paid, however, to the selection of a suitable set of lattice points to cover the regions of pitch space containing most of the source probability.

It is known that in a speech signal where pitch is a meaningful parameter, the evolution of pitch is smooth due to the characteristics of human speech processing mechanism. In general, the pitch period contour of voiced speech evolves slowly in time, and abrupt changes in the contour are very unlikely to happen. It has been found that a rectangular lattice structure is far from being optimal regarding the selection of lattice points to cover the regions of pitch space. Furthermore, in prior art, the search for differential pitch values is performed independently in each dimension. The use of rectangular lattices and the search method have not been optimized to reflect the known behavior of human speech.

It is advantageous and desirable to provide an improved method and system for the quantization of successive pitch periods in speech coders, taking advantage of the source probability in the pitch space to improve the quality of synthesized speech.

Summary of the Invention

It is an aim of embodiments of the present invention to increase the efficiency of coding successive pitch periods thereby improving the quality of synthesized speeches in a speech coder utilizing differential coding to code the difference between successive pitch periods. This aim can be achieved by defining an optimized, or more efficient, lattice structure which is shaped to cover the region of pitch space where the most probable points are located, based on apriori knowledge of the behavior of successive delta periods in voiced speech. Furthermore, regions with different point density representing different time resolution for pitch periods can be defined within the optimized lattice structure. With such an optimized lattice structure, a new method for assigning an index to a point in the optimized lattice structure and the search of the index in a codebook can be provided.

Thus, according to the first aspect of the present invention, there is provided a method of coding a sound signal in a plurality of signal frames each having a pitch period indicative of the sound signal in the respective signal frame, wherein each signal frame comprises a plurality of signal segments each representing a dimension in a pitch space, and the sound signal in each of the signal segments is characterized by a pitch value, and wherein the pitch values are representable by a point distribution pattern characteristic of the sound signal in a lattice structure for defining codebook indices in the pitch space, said method characterized by

shaping the lattice structure based on the point distribution pattern, and by

providing a codebook index representing the pitch value in each dimension of the pitch space according to the shaped lattice structure for facilitating coding of the sound signal.

Preferably, the method comprises

obtaining an open-loop estimate of the pitch period by an open-loop search from the shaped lattice structure considering all of the dimensions of the pitch space, and by

refining the open-loop estimate in each of the dimensions in the pitch space separately by a closed-loop search from the shaped lattice structure for obtaining a closed-loop search value indicative of the pitch value in the respective signal segment.

The pitch value may be indicative of a differential pitch period or an absolute pitch period.

The pitch value in at least one of the signal segments may be indicative of an absolute pitch period and the pitch value in each of the remaining signal segments is indicative of a differential pitch period.

When the signal segments comprise sequentially a first signal segment and three second signal segments, the pitch value in the first signal segment may be indicative of an absolute pitch period and the pitch value in each of the second signal segments is indicative of a differential pitch period.

Alternatively, each of the signal frames comprises four signal segments, and the pitch value in each of the four signal segments is indicative of a differential pitch period.

The signal segments may be arranged in successive subframes. Thus, the pitch value in the first subframe can be an absolute pitch period or a differential pitch period, and the pitch value in each of the remaining subframes is a differential pitch period.

Preferably, each point in the lattice structure represents a distance from a reference point of the pitch space and the lattice structure is shaped to eliminate points that exceed a predetermined distance.

In particular, the shaped lattice structure in some embodiments of the present invention is composed of a union of non-overlapping hypercubes, which are defined by the delta period range and the time resolution in each dimension of the pitch space, and wherein each hypercube is representable by a plurality of edges comprising a number of lattice points. The index of the optimized lattice, in embodiments of the present invention, is indicative of the number of lattice points on the edges of the hypercubes.

A codebook index may be provided and conveyed by an encoding means to a decoding means having information indicative of the shaped lattice, and wherein the decoding means synthesizes speech signal from the codebook index based on the shaped lattice.

According to the second aspect of the present invention, there is provided an apparatus for encoding a sound signal in a plurality of signal frames each having a pitch period indicative of the sound signal in the respective signal frame, wherein each signal frame comprises a plurality of signal segments each representing a dimension in a pitch space, and the sound signal in each of the signal segments is characterized by a pitch value, and wherein the pitch values are representable by a point distribution pattern characteristic of the sound signal in a lattice structure for defining codebook indices in the pitch space, and the lattice structure is shaped based on the point distribution pattern for defining a shaped lattice structure, said apparatus characterized by

means, responsive to the sound signal, for obtaining an open-loop estimate of the pitch period by an open-loop search from the shaped lattice structure considering all of the dimensions of the pitch space for providing an open-loop search value indicative of the open-loop estimate, and by

means, responsive to the open-loop search value, for refining the open-loop estimate in each of the dimensions in the pitch space separately by a closed-loop search from the shaped lattice structure for obtaining a closed-loop search value indicative of the pitch value in the respective signal segment.

One embodiment of the invention may provide a system as defined in claim 19.

Embodiments of the present invention will become apparent upon reading the description taken in conjunction with Figures 2 to 6.

Brief Description of the Drawings

Figure 1 is a diagrammatic representation illustrating a rectangular lattice.
Figure 2 is a diagrammatic representation illustrating a shaped lattice structure.
Figure 3a is a diagrammatic representation illustrating the projection of a hypercube in a two-dimensional plane.
Figure 3b is a diagrammatic representation illustrating the projection of the hypercube in another two-dimensional plane.
Figure 4a is a histogram illustrating a point density distribution in a two-dimensional plane.
Figure 4b is a histogram illustrating a point density distribution in another two-dimensional plane.
Figure 5 is a diagrammatic representation illustrating an encoder, according to the present invention.
Figure 6 is a flowchart illustrating the method of coding a speech signal, according to the present invention.

Best Mode to Carry Out the Invention

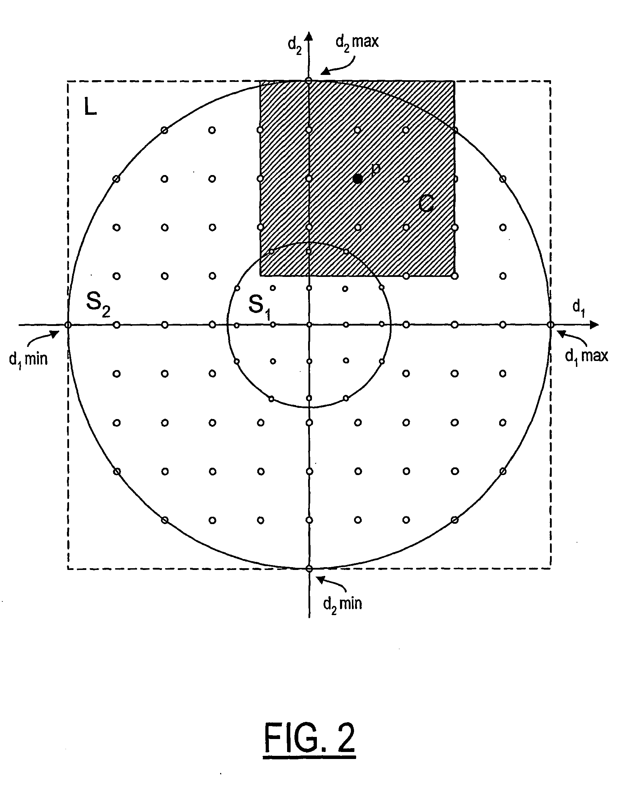

The principle of establishing a shaped lattice structure, according to the present invention, is shown in Figure 2. In general, the lattice points in a pitch space are not evenly distributed. Rather, the distribution is defined by a plurality of regions with different point densities representing different time resolutions for pitch periods. As shown in Figure 2, two sublattices with different point densities, denoted by $S_1$ and $S_2$, exist in the pitch space. The union of these two sublattices, or $S_1 \cup S_2$, represents an optimized lattice structure, $S$, defining the shaped lattice structure.

As mentioned earlier, it is known that the pitch period contour of voiced speech evolves slowly in time, and abrupt changes in the contour are very unlikely to happen. Thus, within a same speech frame, it is very unlikely to have two large delta periods. For example, the corner points $(d_{1min}, d_{2min})$, $(d_{1max}, d_{2min})$, $(d_{1min}, d_{2max})$ and $(d_{1max}, d_{2max})$ and the adjacent points thereof in the lattice $L$, as shown in Figures 1 and 2, represent situation where both the delta period in $d_1$ and the delta period in $d_2$ are large. Since this situation is not likely to occur in voiced speech, these points are very unlikely to be used in a codebook index search. Accordingly, these points can be excluded from the shaped lattice $S$, as shown in Figure 2, without producing noticeable effects on the resulting speech quality. As shown in Figure 2, higher point density in the sublattice $S_1$ allows the use of a finer pitch resolution when pitch period evolves smoothly without significantly increasing the bit rate.

Because of the closed-loop structure of most existing coders utilizing differential coding of the pitch period, the index search in a lattice is carried out in a subframe basis. Thus, the search proceeds sequentially along one coordinate axis of the lattice in time. Generally, this is done by first determining a single open-loop pitch period estimate for the subframes containing the absolute pitch period and the following delta periods. Typically, integer values are used in open-loop search to reduce complexity. Thereafter, the index search is done in a closed-loop fashion sequentially for each dimension. For the first subframe, this is done in the neighborhood of the selected open-loop pitch period. For the other subframes, the search area consists of the neighborhood of the previously selected pitch period.

With the optimized lattice, according to the present invention, this approach is not practical because the possible set of lattice points in each dimension usually depends substantially on the selected point in the previous dimension.

According to the preferred method of the present invention, an estimated open-loop point in the shaped lattice is determined in the multi-dimensional space. The optimal index in each dimension, including the first dimension, is determined thereafter in a closed-loop fashion in the neighborhood of the estimated open-loop point, one dimension at a time. The dot $p$, as shown in Figure 2, represents the estimated open-loop point and the optimal index is searched from the shaded region $C$. The closed-loop search examines the points that belong to the intersection of the shaped lattice S and the search region $C$ centered to the open-loop pitch estimate, $p$. The index determined by the closed-loop search defines uniquely the pitch period over the subframes covered by the lattice. In Figure 2, the shaped lattice $S$ is a subset of the lattice $L$. In general, this is not necessarily the case.

For illustration purposes, the shaped lattice structure is shaped as a union of non-overlapping hypercubes $D_i$, each of which is defined by the delta period range and the time resolution used in a corresponding dimension. Each of the hypercubes $D_i$ is a row of a hypercube matrix **D.** If a speech frame is divided into four subframes and each of the subframes is represented by a dimension in a four-dimensional pitch space, then the ith row of the matrix **D** defines a unique four-dimensional hypercube as follows:

$$D(i,:) = [p_{i\min}\ p_{i\max}\ r_{i0}\ d_{i1\min}\ d_{i1\max}\ r_{i1}\ d_{i2\min}\ d_{i2\max}\ r_{i2}\ d_{i3\min}\ d_{i3\max}\ r_{i3}]\quad(2)$$

where $p_{imin}$, $p_{imax}$ and $r_{i0}$ define the pitch period range and the resolution for the first subframe. The ranges of delta periods in the last three subframes are defined by $d_{ijmin}$ and $d_{ijmax}$, where $j$ is the subframe index. The corresponding resolution in each subframe is denoted by $r_{ij}$.

With the lattice structure described above, the encoding process is quite straightforward. For encoding the index of a certain point in the shaped lattice, a starting index and the number of points in each unique edge of every hypercube are obtained. The encoding process starts by finding the index of the hypercube to which the found pitch period combination ($p, d_1, d_2, d_3$) belongs. The hypercube $D_i$ containing the point ($p, d_1, d_2, d_3$) is defined as

$$D_i = \{(p, d_1, d_2, d_3)\mid p_{i\min} \le p \le p_{i\max} \wedge d_{ji\min} \le d_j \le d_{ij\max}),\ j = 1,2,3\}\quad(3)$$

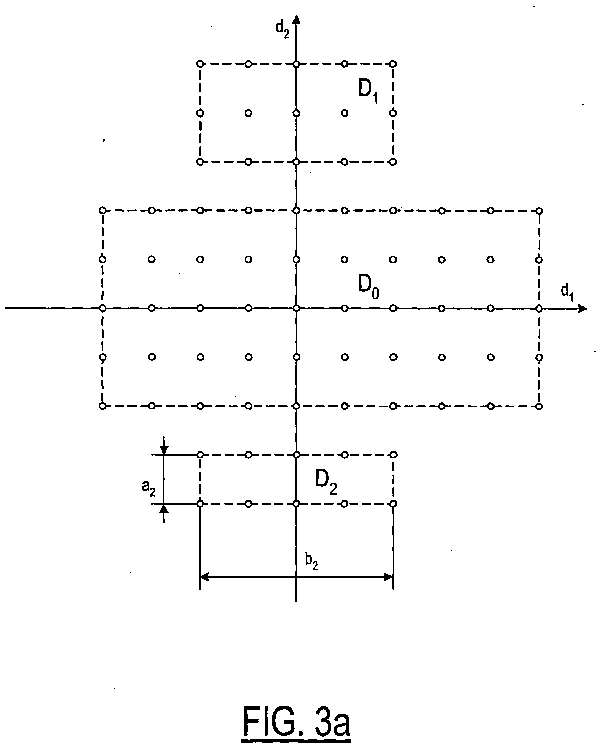

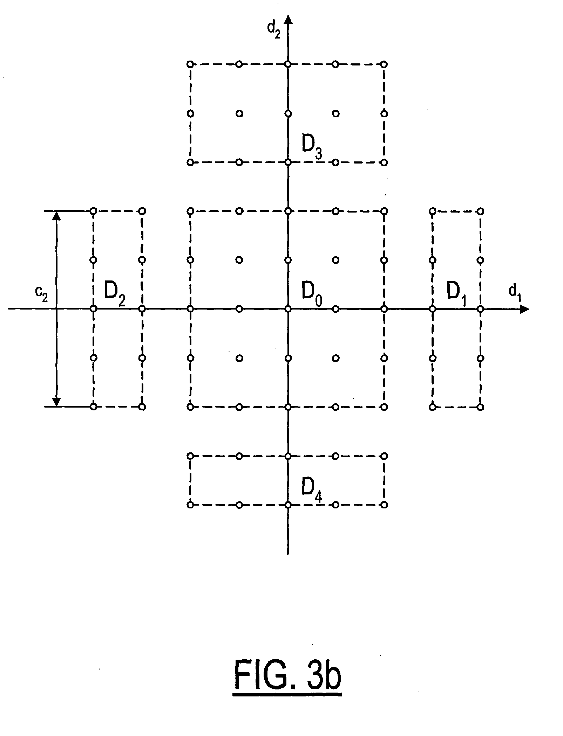

Figure 3a illustrates four hypercubes $D_0, D_1, D_2, D_3$ as projected onto the two-dimensional plane of $d_1, d_2$. Figure 3b illustrates the same hypercubes as projected onto the two-dimensional plane of $d_2, d_3$. It should be noted that, in general, the point density of one hypercube may be different from the point density of another. For simplicity, the circles, as shown in Figures 3a and 3b, are evenly distributed. In Figures 3a and 3b, different hypercubes are shown as enclosed rectangles, each of which can be defined by its unique edges. For example, the hypercube $D_2$ is defined by the edges $a_2, b_2$ and $c_2$.

The optimized or shaped lattice, according to the present invention, has been described in conjunction with Figures 2 to 3b. With the optimized lattice structure, according to the present invention, it is possible to define a set of indices to be transmitted to a decoder for speech synthesis as described below. The index of a point in the hypercube can be assigned by first defining the coordinates of each dimension inside the hypercube $D_i$. The coordinate $p_j$ for the ($j$+1)th subframe is given by

$$p_0 = (p - p_{i\min})r_{i0}\quad(4)$$

$$p_j = (d_j - d_{ji\min})\,r_{ij},\quad \text{for } j = 1,2,3\quad(5)$$

Thus, the index s of the point ($p, d_1, d_2, d_3$) in the shaped lattice can be assigned according to

$$s = s_{Di} + p_0 + p_1 n_{i0} + p_2 n_{i1} n_{i0} + p_3 n_{i2} n_{i1} n_{i0}\quad(6)$$

where $s_{Di}$ is the offset of the hypercube $D_i$. The number of points in each edge of $D_i$ in the ($j$+1)th dimension is denoted by $n_{ij}$. After describing the lattice in a suitable way, the next issue is to find the appropriate boundary values for it.

It should be understood that, the shaped lattice structure, as described above, is for illustration purposes only. The shaped lattice structure is not restricted to those composed of hypercubes. In general, the lattice structure is shaped by choosing the sublattices representing the point distribution pattern characteristic of the speech signal in the speech frame and subframes in a multidimensional pitch space.

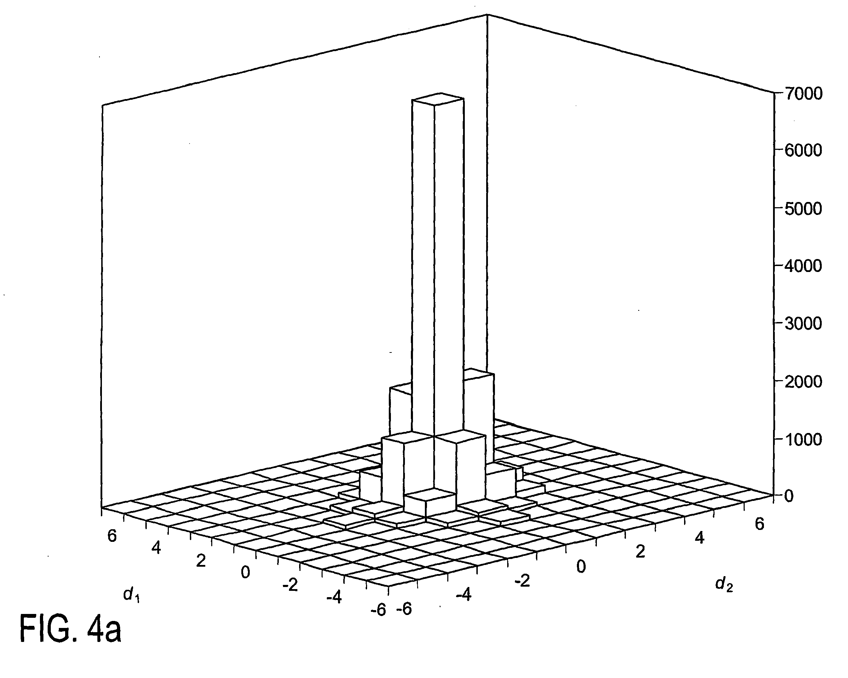

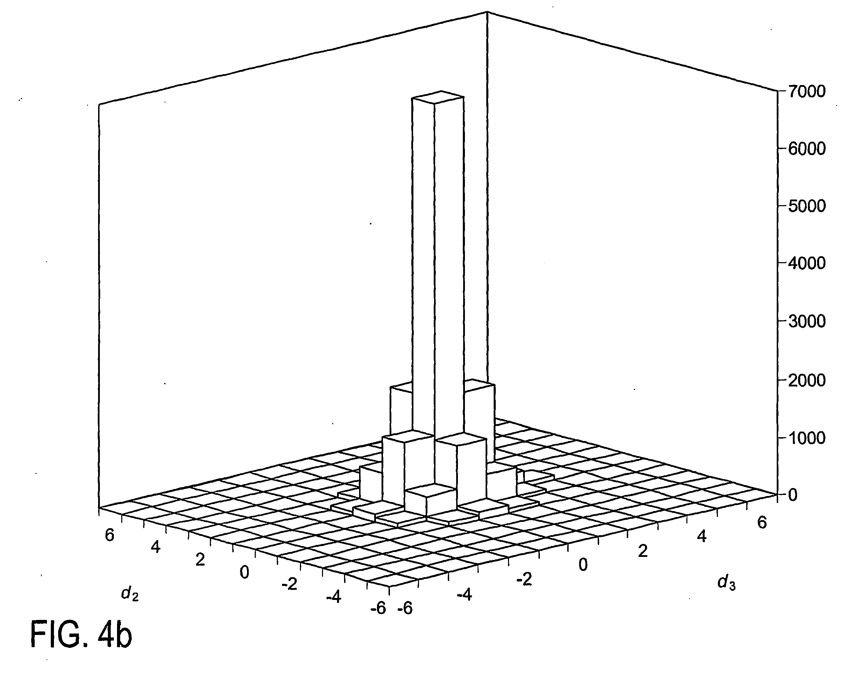

The coding method, according to the present invention, has been implemented in a modified IS-641 speech coder. In the modified IS-641 coder, the first dimension is coded in a usual way such that an absolute pitch period is sent in the first subframe. However, the shaped lattice structure including four hypercubes is used for coding the remaining three dimensions. It should be noted that, in a regular IS-641 coder, only two delta periods are sent for subframes 2 and 4. In the modified IS-641 coder, three delta periods are sent instead. Based on an experiment using 39434 frames of American-English speech spoken by a number of talkers, the distribution of delta periods derived from speech segments using the modified IS-641 speech coder is shown in Figures 4a and 4b. For simplicity, the delta period range is limited to $\pm 6$ samples. The difference between the pitch periods of the $(i+1)$th subframe and the ith subframe is denoted by $d_i$. The delta periods are rounded to integer values in the Figures 4a and 4b although 1/3 resolution is used in the simulation. The point-density distribution in the $d_1$, $d_2$ plane and that in the $d_2$, $d_3$ plane are shown in Figures 4a and 4b, respectively. As shown in Figures 4a and 4b, the combinations of two large delta values are rare. That is, when $d_1$ is large, $d_2$ and $d_3$ are small. But when $d_2$ or $d_3$ is large, $d_1$ is small. Thus, there is an interdependency among the delta periods in the subframe. In the prior art coder, each dimension is treated independently of each other, disregarding the interdependency among the delta periods in the subframes. In the modified IS-641, according to the present invention, the open-loop pitch value is the average pitch for the frame. The open-loop pitch value is estimated jointly in each dimension using integer resolution. This open-loop estimate is refined using closed-loop search sequentially in each dimension. For example, the closed loop-value for the first subframe is search around the estimated open-loop pitch value. The closed-loop value for the second subframe is selected around the rounded, optimal closed-loop pitch of the first subframe and so on. The possible integer value for the first sub frame ranges from 20-147. As shown in Figures 4a and 4b, the lattice structure used is symmetric with respect to axes $d_1$, $d_2$ and $d_3$. Thus, the three dimensional lattice regarding the delta periods can be unambiguously defined by one corner point of the projection of $D_0$ to axes $d_1$ and $d_2$. In the experiment, three different optimized lattices (Shaped Lattice $S_A$, Shaped Lattice $S_B$ and Shape Lattice $S_C$) are implemented with corner points of $(2\frac{2}{3}, 1\frac{2}{3})$, $(2\frac{2}{3}, \frac{2}{3})$ and $(1\frac{2}{3}, \frac{2}{3})$, respectively, being used as the offset $s_{Di}$. As a reference, two cubic quantizers (Lattice $L_1$, Lattice $L_2$) with maximum delta periods of $2\frac{2}{3}$ and $1\frac{2}{3}$ are used. These ranges are selected based on the distributions presented in Figures 4a and 4b. The simulation results are presented in Table 1. The results are expressed as segmental signal-to-noise ratios (SegSNR) between the voiced sections of the input speech and synthesized speech, together with the number of bits needed for the coding of the delta periods in each frame. A segment length of 64 samples is used and silent segments are discarded in the SegSNR computation. The speech sample used in all simulations consist of four sentences spoken by two male and two female talkers in clean conditions. The total length of sample is 782 frames. As it can be seen from Table I, the coding efficiency of successive pitch periods can be increased by using the optimized lattice structure, according to the present invention.

TABLE I

|  | Lattice $L_1$ | Lattice $L_2$ | Shaped Lattice $S_A$ | Shaped Lattice $S_B$ | Shaped Lattice $S_c$ |
|---|---|---|---|---|---|
| SegSNR / dB | 8.24 | 8.09 | 8.28 | 8.11 | 8.05 |
| No. of bits | 12.26 | 10.38 | 11.78 | 10.00 | 9.17 |

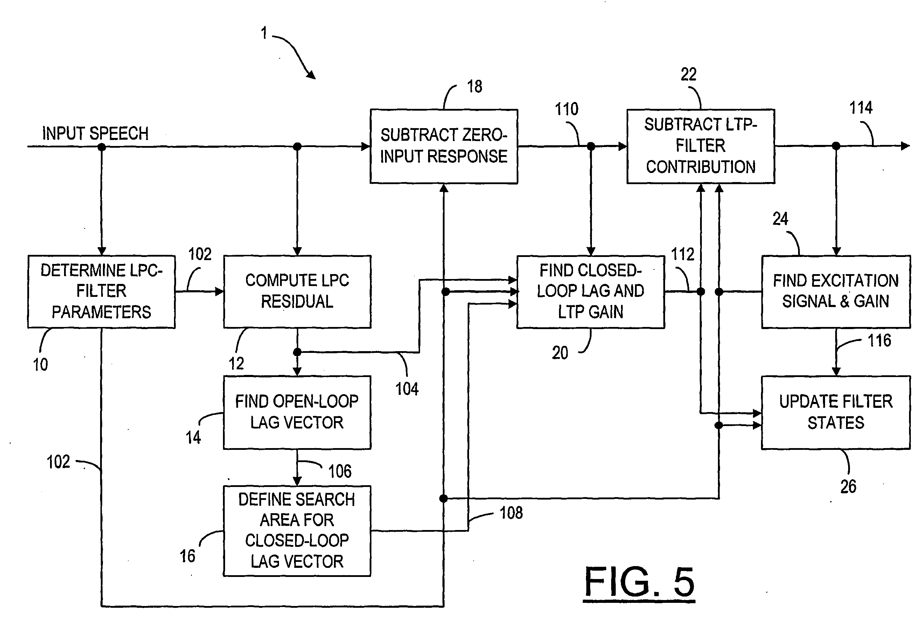

The speech encoder 1, according to the present invention, is shown in Figure 5. It is based on the coding technique known as Analysis-by-Synthesis (AbS), employing linear predictive coding (LPC) technique. Typically, a cascade of time variant pitch predictor and LPC filter is used. As shown in Figure 5, an LPC analysis unit 10 is used to determine the coefficients **102** of the LPC filter based on the input speech signal. Usually, the speech signal is high-pass filtered in a pre-processing step. The preprocessed speech signal is then windowed, and autocorrelations of the windowed speech are computed. The LPC filter coefficients **102** are determined, for example, using the Levinson-Durbin algorithm. In most coders, the coefficients are not determined in every subframe. In such cases, the coefficients can be interpolated for the intermediate subframes. The pre-processing step and the LPC analysis step are known in the art. The input speech is further filtered with an inverse filter $A(q,s)$ **12** to produce a residual signal **104**. The residual signal **104** is sometimes referred to as the ideal excitation. From the shaped lattice, which is determined from *a priori* knowledge on the distribution of successive pitch values, an open-loop search unit **14** is used to determine an open-loop lag estimate vector **106** for the whole frame. In general, the length of the vector 106 is the same as the number of subframes, with elements corresponding to lag estimates for the individual subframes. It is also possible to search for the estimate vector **106** using the speech signal instead of the LPC residual signal **104**. As all the subframes constitute the dimensions of the multi-dimensional pitch space, the search for the estimate vector **106** takes into account all these dimensions. The open-loop estimate **106** provides an open-loop lag value for each dimension in the pitch space. A search-area defining unit **16** is used to define the closed-loop search area **108** for the closed-loop lag vector in each dimension of the pitch space, based on the shaped lattice. For example, the unit **16** examines the points that belong to the intersection of the shaped lattice *S* and the search region C centered to the open-loop pitch estimate *p,* as shown in Figure 2. From the input speech signal, a target signal **110** for the closed-loop lag search is computed in a computing unit **18** by subtracting the zero input response of the LPC filter **10** from the input speech signal, taking into account the effect of the initial states of the LPC filter **10.** A closed-loop search unit **20** is used to refine the open-loop estimate **106,** one dimension at a time, based on the corresponding open-loop lag value using the lattice points in the shaped lattice in that dimension for obtaining the codebook index. The codebook index is contained in the signal **112.** In particular, the closed-loop search unit **20** searches for the closed-loop lag and gain by minimizing the sum-squared error between the target signal **110** for the closed-loop lag search and the synthesized speech signal represented by the LPC coefficients **102** and the LPC excitation signal. The closed-loop lag in each subframe is searched around the corresponding open-loop lag value in the defined search area **108.** For lag values less than the subframe length, LTP (Long Term Predictor) memory has to be extended. This can be done by using the residual signal **104,** or by copying old LTP excitation. The extension of LTP memory is known in the art. The target signal **114** for the excitation search is computed in an innovation codebook search unit **22** by subtracting the contribution **110** of the LTP filter from the target signal **112** of the closed loop lag search. The excitation signal and its gains, as collectively denoted by reference numeral **116,** are searched in a computation unit **24** by minimizing the sum-squared error between the target signal **114** for the excitation search and the synthesized speech signal represented by the LPC coefficients **102** and the excitation signal. Usually, some heuristic rules are employed to avoid an exhaustive search of all possible excitation signal candidates. Finally, the filter states in the encoder **1** are updated in an updating **26** unit to keep them consistent with the filter states in the decoder. The codebook search unit **22,** the computation unit **24** and the updating unit **26** are known in the art. The encoder **1,** as described above, is applicable to a typical AbS or CELP coder such as IS-641.

It should be noted that, as the decoder receives the speech parameters from the encoder, the LTP excitation signal is determined by the received index and gain based on the same shaped lattice known to the decoder.

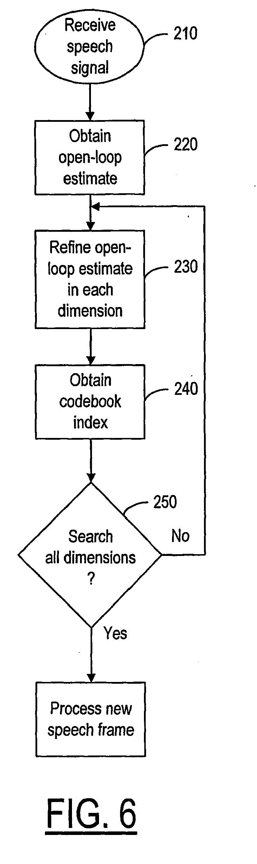

Figure 6 is a flowchart illustrating the method of encoding a speech signal, according to the present invention. As shown in Figure 6, as the encoder receives a speech signal at step **210,** the speech signal is processed in speech frames and subframes, as known in prior art. At step **220,** an open-loop search is carried out considering all the dimensions in the pitch space for obtaining an open-loop estimate of the pitch period in a speech frame. At step **230,** a closed-loop search is carried out for each dimension separately to refine the open-loop estimate for obtaining a pitch value. Based on the pitch value obtained from the closed-loop search for each dimension, a codebook index is obtained at step **240.** The closed-loop search for each dimension continues until the codebook indices for all subframes in a speech frame are obtained, as indicated by step **250.** It should be noted that the pitch value in the first dimension of the pitch space (the first subframe for each speech frame) can be indicative of the absolute pitch period or a different pitch period (delta pitch). However, the pitch value for each of the remaining dimensions is indicative of the different pitch period in the respective subframe.

It should be understood that the present invention has been described in conjunction with the coding of a speech signal. However, the present invention is also applicable to non-speech signals, such as music.

Furthermore, while it is preferable to divide a speech frame into a plurality of subframes and search for a closed-loop pitch value in each subframe, it is possible to search for a closed-loop pitch value for a different segment of the speech frame. In general, it is possible to send different parameters a number of times per speech frame to the decoder.

Thus, although the invention has been described with respect to a preferred embodiment thereof, it will be understood by those skilled in the art that the foregoing and various other changes, omissions and deviations in the form and detail thereof may be made without departing from the scope of this invention, which is defined by the appended claims.

**Claims**

1. A method of coding a sound signal in a plurality of signal frames each having a

   pitch period indicative of the sound signal in the respective signal frame, wherein each signal frame comprises a plurality of signal segments each representing a dimension in a pitch space, and the sound signal in each of the signal segments is **characterized by** a pitch value, and wherein the pitch values are representable by a point distribution pattern characteristic of the sound signal in a lattice structure for defining codebook indices in the pitch space, said method **characterized by**
   shaping the lattice structure based on the point distribution pattern, and by
   providing a codebook index (240) representing the pitch value in each dimension of the pitch space according to the shaped lattice structure for facilitating coding of the sound signal.

2. The method of claim 1, further **characterized by**
   obtaining an open-loop estimate of the pitch period by an open-loop search from the shaped lattice structure considering all of the dimensions of the pitch space, and by
   refining the open-loop estimate in each of the dimensions in the pitch space separately by a closed-loop search from the shaped lattice structure for obtaining a closed-loop search value indicative of the pitch value in the respective signal segment.

3. The method of claim 2, **characterized in that** the pitch value is indicative of a differential pitch period.

4. The method of claim 2, **characterized in that** the pitch value in at least one of the signal segments is indicative of an absolute pitch period and the pitch value in each of the remaining signal segments is indicative of a differential pitch period.

5. The method of claim 2, **characterized in that** the successive signal segments sequentially comprise a first signal segment and three second signal segments, and wherein the pitch value in the first signal segment is indicative of an absolute pitch period and the pitch value in each of the second signal segments is indicative of a differential pitch period.

6. The method of claim 2, **characterized in that** the signal segments are arranged in subframes.

7. The method of claim 6, **characterized in that** each of the signal frames comprises four subframes, and wherein the pitch value in each of the four subframes is indicative of a differential pitch period.

8. The method of claim 6, **characterized in that** the subframes include sequentially a first subframe and three second subframes and where the pitch value in the first subframe is an absolute pitch period, and the pitch value in each of the second subframes is a differential pitch period.

9. The method of claim 1, **characterized in that** the point density pattern is comprised of a plurality of regions in the shaped lattice structure and each of the regions is representable of a hypercube, each having a plurality of edges comprising one or more lattice points of the shaped lattice structure, and wherein the codebook index is indicative of the number of lattice points on the edges of the hypercubes.

10. The method of claim 1, **characterized in that** the codebook index is provided by an encoding means to a decoding means having information indicative of the shaped lattice structure for allowing the decoding means to synthesize a speech signal from the codebook index based on the shaped lattice structure.

11. The method of claim 1, **characterized in that** the sound signal comprises a speech signal.

12. An apparatus (1) for encoding a sound signal in a plurality of signal frames each having a pitch period indicative of the sound signal in the respective signal frame, wherein each signal frame comprises a plurality of signal segments each representing a dimension in a pitch space, and the sound signal in each of the signal segments is **characterized by** a pitch value, and wherein the pitch values are representable by a point distribution pattern characteristic of the sound signal in a lattice structure for defining codebook indices in the pitch space, and the lattice structure is shaped based on the point distribution pattern for defining a shaped lattice structure, said apparatus **characterized by** means (106) responsive to the sound signal, for obtaining an open-loop estimate of the pitch period by an open-loop search from the shaped lattice structure considering all of the dimensions of the pitch space for providing an open-loop search value indicative of the open-loop estimate, and by means (20), responsive to the open-loop search value, for refining the open-loop estimate in each of the dimensions in the pitch space separately by a closed-loop search from the shaped lattice structure for obtaining a closed-loop search value indicative of the pitch value in the respective signal segment.

13. The apparatus of claim 12, **characterized in that** the pitch value is indicative of a differential pitch period.

14. The apparatus of claim 12, **characterized in that** the pitch value in at least one of the signal segments is indicative of an absolute pitch period and the pitch value in each of the remaining signal segments is indicative of a differential pitch period.

15. The apparatus of claim 12, **characterized in that** the signal segments are arranged in successive subframes.

16. The apparatus of claim 15, **characterized in that** the successive subframes sequentially comprise a first subframe and three second subframes, and wherein the pitch value in the first sub frame is indicative of an absolute pitch period and the pitch value in each of the second subframes is indicative of a differential pitch period.

17. The apparatus of claim 15, **characterized in that** each of the signal frames comprises four subframes, and wherein the pitch value in each of the four subframes is indicative of a differential pitch period.

18. The apparatus of claim 12, **characterized in that** the point density pattern is comprised of a plurality of regions in the shaped lattice structure and each of the regions is representable of a hypercube, each having a plurality of edges comprising one or more lattice points of the shaped lattice structure, and wherein the codebook index is indicative of the number of lattice points on the edges of the hypercubes.

19. A system comprising an apparatus as claimed in any of claims 12 to 18,

> said means, responsive to the open-loop search value, providing information indicative of the shaped lattice structure and the codebook indices,
> said system further comprising
> a decoder having means, responsive to the information, for synthesizing a further sound signal from the codebook indices based on the shaped lattice structure.

**Patentansprüche**

1. Verfahren zum Kodieren eines Klangsignals in einer Vielzahl von Signaldatenübertragungsrahmen, die jeder eine Tonhöhenperiode aufweisen, die bezeichnend für das Klangsignal in dem jeweiligen Signaldatenübertragungsrahmen ist, wobei jeder Signaldatenübertragungsrahmen eine Vielzahl von Signalsegmenten aufweist, die jeweils eine Dimension in einem Tonhöhenraum repräsentieren, und wobei das Klangsignal in jedem der Signalsegmente durch einen Tonhöhenwert **gekennzeichnet** ist, und wobei die Tonhöhenwerte durch ein Punktverteilungsmuster repräsentiert werden können, das kennzeichnend für das Klangsignal in einer Gitterstruktur zum Definieren von Codebuchindizes in dem Tonhöhenraum ist, wobei das Verfahren **gekennzeichnet ist durch**:

> Ausbilden der Gitterstruktur auf Grundlage des Punktverteilungsmusters, und **durch**
> Bereitstellen eines Codebuchindex (240), der den Tonhöhenwert in jeder Dimension des Tonhöhenraums gemäß der ausgebildeten Gitterstruktur repräsentiert, um das Kodieren des Klangsignals zu vereinfachen.

2. Verfahren nach Anspruch 1, ferner **gekennzeichnet durch**
Erhalten einer offene Regelkreis Schätzung der Tonhöhenperiode **durch** eine offene Regelkreis Suche aus der ausgebildeten Gitterstruktur, die alle Dimensionen des Tonhöhenraumes betrachtet, und **durch**
Verfeinern der offene Regelkreis Schätzung getrennt in jeder der Dimensionen in dem Tonhöhenraum **durch** eine geschlossene Regelkreis Suche von der ausgebildeten Gitterstruktur zum Erhalten eines geschlossenen Regelkreis Suchwerts, der bezeichnend für den Tonhöhenwert in dem jeweiligen Signalsegment ist.

3. Verfahren nach Anspruch 2, **dadurch gekennzeichnet, dass** der Tonhöhenwert bezeichnend für eine differentielle Tonhöhenperiode ist.

4. Verfahren nach Anspruch 2, **dadurch gekennzeichnet, dass** der Tonhöhenwert in zumindest einem der Signalsegmente bezeichnend für eine absolute Tonhöhenperiode ist und der Tonhöhenwert in jedem der verbleibenden Signalsegmente bezeichnend für eine differentielle Tonhöhenperiode ist.

5. Verfahren nach Anspruch 2, **dadurch gekennzeichnet, dass** die aufeinander folgenden Signalsegmente nacheinander ein erstes Signalsegment und drei zweite Signalsegmente aufweisen, und wobei der Tonhöhenwert in dem ersten Signalsegment bezeichnend für eine absolute Tonhöhenperiode und der Tonhöhenwert in jedem der zweiten Signalsegmente bezeichnend für eine differentielle Tonhöhenperiode ist.

6. Verfahren nach Anspruch 2, **dadurch gekennzeichnet, dass** die Signalsegmente in Unterdatenübertragungsblökken angeordnet sind.

7. Verfahren nach Anspruch 6, **dadurch gekennzeichnet, dass** jeder der Signaldatenübertragungsrahmen vier Unterdatenübertragungsrahmen aufweist, und wobei der Tonhöhenwert in jedem der vier Unterdatenübertragungsrahmen bezeichnend für eine differentielle Tonhöhenperiode ist.

8. Verfahren nach Anspruch 6, **dadurch gekennzeichnet, dass** die Unterdatenübertragungsrahmen aufeinanderfolgend einen ersten Unterdatenübertragungsrahmen und drei zweite Unterdatenübertragungsrahmen beinhalten, und wobei der Tonhöhenwert in dem ersten Unterdatenübertragungsrahmen eine absolute Tonhöhenperiode und der Tonhöhenwert in jedem der zweiten Unterdatenübertragungsrahmen eine differentielle Tonhöhenperiode ist.

9. Verfahren nach Anspruch 1, **dadurch gekennzeichnet, dass** das Punktdichtemuster eine Vielzahl von Bereichen in der ausgebildeten Gitterstruktur aufweist, und jeder der Bereiche durch einen Hyperkubus repräsentiert werden kann, der jeder eine Vielzahl von Kanten aufweist, die einen oder mehr Gitterpunkte der ausgebildeten Gitterstruktur aufweisen, und wobei der Codebuchindex bezeichnend für die Anzahl der Gitterpunkte auf den Kanten der Hyperkuben ist.

10. Verfahren nach Anspruch 1, **dadurch gekennzeichnet, dass** der Codebuchindex durch eine Codiereinrichtung an eine Decodiereinrichtung bereitgestellt wird, die eine Information aufweist, die bezeichnend für die ausgebildete Gitterstruktur ist, um der Decodiereinrichtung zu ermöglichen, ein Sprachsignal aus dem Codebuchindex auf Grundlage der ausgebildeten Gitterstruktur zu synthetisieren.

11. Verfahren nach Anspruch 1, **dadurch gekennzeichnet, dass** das Klangsignal ein Sprachsignal aufweist.

12. Vorrichtung (1) zum Kodieren eines Klangsignals in einer Vielzahl von Signaldatenübertragungsrahmen, die jeder eine Tonhöhenperiode aufweisen, die bezeichnend für das Klangsignal in dem jeweiligen Signaldatenübertragungsrahmen ist, wobei jeder Signaldatenübertragungsrahmen eine Vielzahl von Signalsegmenten aufweist, die jeweils eine Dimension in einem Tonhöhenraum repräsentieren, und wobei das Klangsignal in jedem der Signalsegmente durch einen Tonhöhenwert **gekennzeichnet** ist, und wobei die Tonhöhenwerte durch ein Punktverteilungsmuster repräsentiert werden können, das kennzeichnend für das Klangsignal in einer Gitterstruktur zum Definieren von Codebuchindizes in dem Tonhöhenraum ist, und wobei die Gitterstruktur auf Grundlage des Punktverteilungsmusters zum Definieren einer ausgebildeten Gitterstruktur ausgebildet ist, wobei die Vorrichtung **gekennzeichnet ist durch** eine Einrichtung (106), die auf das Klangsignal reagiert, um eine offene Regelkreis Schätzung der Tonhöhenperiode **durch** eine offene Regelkreis Suche aus der ausgebildeten Gitterstruktur zu erhalten, die alle Dimensionen des Tonhöhenraumes betrachtet, um einen Offenen Regelkreis Suchwert bereitzustellen, der bezeichnend für die Offene Regelkreis Schätzung ist, und **durch** eine Einrichtung (20), die auf den offenen Regelkreis Suchwert reagiert, zum Verfeinern der offene Regelkreis Schätzung getrennt in jeder der Dimensionen in dem Tonhöhenraum **durch** eine geschlossene Regelkreis Suche aus der ausgebildeten Gitterstruktur zum Erhalten eines geschlossenen Regelkreis Suchwerts, der bezeichnend für den Tonhöhenwert in dem jeweiligen Signalsegment ist.

13. Vorrichtung nach Anspruch 12, **dadurch gekennzeichnet, dass** der Tonhöhenwert bezeichnend für eine differentielle Tonhöhenperiode ist.

14. Vorrichtung nach Anspruch 12, **dadurch gekennzeichnet, dass** der Tonhöhenwert in zumindest einem der Signalsegmente bezeichnend für eine absolute Tonhöhenperiode ist und der Tonhöhenwert in jedem der verbleibenden Signalsegmente bezeichnend für eine differentielle Tonhöhenperiode ist.

15. Vorrichtung nach Anspruch 12, **dadurch gekennzeichnet, dass** die Signalsegmente in aufeinander folgenden Unterdatenübertragungsblöcken angeordnet sind.

16. Vorrichtung nach Anspruch 15, **dadurch gekennzeichnet, dass** die aufeinander folgenden Unterdatenübertragungsblöcke nacheinander einen ersten Unterdatenübertragungsblock und drei zweite Unterdatenübertragungsblöcke aufweisen, und wobei der Tonhöhenwert in dem ersten Unterdatenübertragungsblock bezeichnend für eine absolute Tonhöhenperiode und der Tonhöhenwert in jedem der zweiten Unterdatenübertragungsblöcke bezeichnend für eine differentielle Tonhöhenperiode ist.

17. Vorrichtung nach Anspruch 15, **dadurch gekennzeichnet, dass** jeder der Signaldatenübertragungsrahmen vier Unterdatenübertragungsrahmen aufweist, und wobei der Tonhöhenwert in jedem der vier Unterdatenübertragungsrahmen bezeichnend für eine differentielle Tonhöhenperiode ist.

18. Vorrichtung nach Anspruch 12, **dadurch gekennzeichnet, dass** das Punktdichtemuster eine Vielzahl von Bereichen in der ausgebildeten Gitterstruktur aufweist, und jeder der Bereiche durch einen Hyperkubus repräsentiert werden kann, der jeder eine Vielzahl von Kanten aufweist, die einen oder mehr Gitterpunkte der ausgebildeten Gitterstruktur aufweisen, und wobei der Codebuchindex bezeichnend für die Anzahl der Gitterpunkte auf den Kanten der Hyperkuben ist.

19. System, das eine Vorrichtung nach einem der Ansprüche 12 bis 18 aufweist, wobei
die Einrichtung, die auf den offenen Regelkreis Suchwert reagiert, eine Information bereitstellt, die bezeichnend für die ausgebildete Gitterstruktur und die Codebuchindizes ist, wobei
das System ferner aufweist
eine einen Decodierer aufweisende Einrichtung, die auf die Information reagiert, um ein weiteres Klangsignal aus den Codebuchindizes auf Grundlage der ausgebildeten Gitterstruktur zu synthetisieren.

## Revendications

1. Procédé de codage d'un signal sonore dans une pluralité de trames de signal ayant chacune une période fondamentale indicative du signal sonore dans la trame de signal correspondante, dans lequel chaque trame de signal comprend une pluralité de segments de signal représentant chacun une dimension dans un espace fondamental, et le signal sonore dans chacun des segments de signal est **caractérisé par** une valeur fondamentale, et dans lequel les valeurs fondamentales sont représentables par un modèle de distribution de points caractéristique du signal sonore dans une structure en treillis pour définir les index de livre de codes dans l'espace fondamental, ledit procédé étant **caractérisé par**
le façonnage de la structure en treillis sur la base du modèle de distribution de points, et
la fourniture d'un index de livre de codes (240) représentant la valeur fondamentale dans chaque dimension de l'espace fondamental selon la structure en treillis façonnée pour faciliter le codage du signal sonore.

2. Procédé selon la revendication 1, **caractérisé par**
l'obtention d'une estimation en boucle ouverte de la période fondamentale par une recherche en boucle ouverte à partir de la structure en treillis façonnée en considérant l'ensemble des dimensions de l'espace fondamental, et l'affinement de l'estimation en boucle ouverte dans chacune des dimensions dans l'espace fondamental séparément par une recherche en boucle fermée à partir de la structure en treillis façonnée pour obtenir une valeur de recherche en boucle fermée indicative de la valeur fondamentale dans le segment de signal correspondant.

3. Procédé selon la revendication 2, **caractérisé en ce que** la valeur fondamentale est indicative d'une période fondamentale différentielle.

4. Procédé selon la revendication 2, **caractérisé en ce que** la valeur fondamentale dans au moins un des segments de signal est indicative d'une période fondamentale absolue et la valeur fondamentale dans chacun des segments de signal restants est indicative d'une période fondamentale différentielle.

5. Procédé selon la revendication 2, **caractérisé en ce que** les segments de signal successifs comprennent en séquence un premier segment de signal et trois seconds segments de signal, et dans lequel la valeur fondamentale dans le premier segment de signal est indicative d'une période fondamentale absolue et la valeur fondamentale dans chacun des seconds segments de signal est indicative d'une période fondamentale différentielle.

6. Procédé selon la revendication 2, **caractérisé en ce que** les segments de signal sont agencés en sous-trames.

7. Procédé selon la revendication 6, **caractérisé en ce que** les trames de signal comprennent quatre sous-trames, et dans lequel la valeur fondamentale dans chacune des quatre sous-trame est indicative d'une période fondamentale différentielle.

8. Procédé selon la revendication 6, **caractérisé en ce que** les sous-trames incluent en séquence une première sous-trame et trois secondes sous-trames et dans lequel la valeur fondamentale dans la première sous-trame est une période fondamentale absolue, et la valeur fondamentale dans chacune des secondes sous-trames est une période fondamentale différentielle.

9. Procédé selon la revendication 1, **caractérisé en ce que** le modèle de densité de points est composé d'une pluralité de régions dans la structure en treillis façonnée et chacune des régions est la représentation d'un hypercube, ayant chacun une pluralité de bords comprenant un ou plusieurs points de treillis de la structure en treillis façonnée, et dans lequel l'index de livre de codes est indicatif du nombre de points de treillis sur les bords des hypercubes.

**10.** Procédé selon la revendication 1, **caractérisé en ce que** l'index de livre de codes est fourni par des moyens de codage à des moyens de décodage ayant des informations indicatives de la structure en treillis façonnée pour permettre aux moyens de décodage de synthétiser un signal de parole à partir de l'index de livre de codes sur la structure en treillis façonnée.

**11.** Procédé selon la revendication 1, **caractérisé en ce que** le second signal comprend un signal de parole.

**12.** Appareil (1) de codage d'un signal sonore dans une pluralité de trames de signal ayant chacune une période fondamentale indicative du signal sonore dans la trame de signal correspondante, dans lequel chaque trame de signal comprend une pluralité de segments de signal représentant chacun une dimension dans un espace fondamental, et le signal sonore dans chacun des segments de signal est **caractérisé par** une valeur fondamentale, et dans lequel les valeurs fondamentales sont représentables par un modèle de distribution de points caractéristique du signal sonore dans une structure en treillis pour définir des index de livre de codes dans l'espace fondamental, et la structure en treillis est façonnée en se basant sur le modèle de distribution de points pour définir une structure en treillis façonnée,
ledit appareil étant **caractérisé par**
des moyens (106) sensibles au signal sonore, pour obtenir une estimation en boucle ouverte de la période fondamentale par une recherche en boucle ouverte à partir de la structure en treillis façonnée en considérant l'ensemble des dimensions de l'espace fondamental pour fournir une valeur de recherche en boucle ouverte indicative de l'estimation en boucle ouverte, et par
des moyens (20), sensibles à la valeur de recherche en boucle ouverte, pour affiner l'estimation en boucle ouverte dans chacune des dimensions dans l'espace fondamental séparément par une recherche en boucle fermée à partir de la structure en treillis façonnée pour obtenir une valeur de recherche en boucle fermée indicative de la valeur fondamentale dans le segment de signal respectif.

**13.** Appareil selon la revendication 12, **caractérisé en ce que** la valeur fondamentale est indicative d'une période fondamentale différentielle.

**14.** Appareil selon la revendication 12, **caractérisé en ce que** la valeur fondamentale dans au moins un des segments de signal est indicative d'une période fondamentale absolue et la valeur fondamentale dans chacun des segments de signal restants est indicative d'une période fondamentale différentielle.

**15.** Appareil selon la revendication 12, **caractérisé en ce que** les segments de signal sont agencés en sous-trames successives.

**16.** Appareil selon la revendication 15, **caractérisé en ce que** les sous-trames successives comprennent en séquence une première sous-trame et trois secondes sous-trames et dans lequel la valeur fondamentale dans la première sous-trame est indicative d'une période fondamentale absolue, et la valeur fondamentale dans chacune des secondes sous-trames est indicative d'une période fondamentale différentielle.

**17.** Appareil selon la revendication 15, **caractérisé en ce que** chacune des trames de signal comprend quatre sous-trames, et dans lequel la valeur fondamentale dans chacune des quatre sous-trame est indicative d'une période fondamentale différentielle.

**18.** Appareil selon la revendication 12, **caractérisé en ce que** le modèle de densité de points est composé d'une pluralité de régions dans la structure en treillis façonnée et chacune des régions est la représentation d'un hypercube, ayant chacun une pluralité de bords comprenant un ou plusieurs points de treillis de la structure en treillis façonnée, et dans lequel l'index de livre de codes est indicatif du nombre de points de treillis sur les bords des hypercubes.

**19.** Système comprenant un appareil selon l'une quelconque des revendications 12 à 18,
lesdits moyens, réceptifs à la valeur de recherche en boucle ouverte, fournissant des informations indicatives de la structure en treillis façonnée et des indices de livre de codes
ledit système comprenant en outre
un décodeur ayant des moyens, réceptifs aux informations, pour synthétiser un autre signal sonore à partir des indices de livre de codes sur la base de la structure en treillis façonnée.

FIG. 1

**FIG. 2**

## FIG. 3a

## FIG. 3b

FIG. 4a

FIG. 4b

**FIG. 5**

EP 1 428 202 B1

Receive speech signal — 210

↓

Obtain open-loop estimate — 220

↓

Refine open-loop estimate in each dimension — 230

↓

Obtain codebook index — 240

↓

Search all dimensions ? — 250

No →

Yes

↓

Process new speech frame

## FIG. 6

**REFERENCES CITED IN THE DESCRIPTION**

**Patent documents cited in the description**

- US 5778334 A